# EUROPEAN PATENT APPLICATION

(11) **EP 2 478 999 A2**
(43) Date of publication of application: **25.07.2012**
(21) Application number: 12000278.7
(22) Date of filing: 18.01.2012
(51) Int. Cl.: B24B 37/04, B24B 37/015

(54) **Polishing method and polishing apparatus**

(30) Priority: 20.01.2011 JP 2011009612
(71) Applicant: EBARA CORPORATION, Ohta-ku, Tokyo (JP)
(72) Inventor: Ono, Katsutoshi, Tokyo (JP); Matsuo, Hisanori, Tokyo (JP)
(74) Representative: Schmidbauer, Andreas Konrad

(57) **Abstract**

A polishing method polishes a surface (surface to be polished) of a substrate at a sufficient polishing rate and obtains a desired polishing profile while preventing an unpolished portion from remaining on the surface of the substrate after polishing. The polishing method polishes a surface to be polished with a polishing pad while controlling the temperature of the polishing pad by blowing a gas toward the polishing pad. The polishing method includes monitoring the polishing state of the substrate to be polished during polishing while PID-controlling the flow rate or the blow direction of the gas, and changing the control temperature of the polishing pad when a predetermined thickness of a film to be polished is reached.

## Description

### BACKGROUND OF THE INVENTION

### Field of the Invention:

The present invention relates to a polishing method and apparatus for polishing a surface (surface to be polished) of a substrate, such as a semiconductor wafer, by pressing the surface of the substrate against a polishing surface of a polishing pad while moving the surface of the substrate and the polishing surface relative to each other.

### Description of the Related Art:

A chemical mechanical polishing (CMP) apparatus is known which polishes a surface to be polished of a substrate, such as a semiconductor wafer, into a flat surface by a method comprising pressing the surface of the substrate, held by a polishing head (substrate holding mechanism), against a polishing surface of a polishing pad, attached to an upper surface of a polishing table, while rotating the polishing table and the polishing head to move the surface of the substrate and the polishing surface relative to each other, and supplying a slurry to the polishing surface.

As is known in the CMP art, the temperature of a polishing pad changes with time as polishing progresses, and the temperature change in the polishing pad affects the polishing rate, the polishing profile after polishing, etc.

Various methods have therefore been proposed, including a method which involves controlling the temperature of a surface of a polishing pad at a temperature of not more than about 50°C, e.g., 44°C, in order to reduce dishing (see Japanese Patent Laid-Open Publication No. 2001-308040), and a method which involves monitoring the temperature of a surface of a polishing cloth, and controlling an amount of a second chemical, supplied to the polishing cloth, according to change in the surface temperature of the polishing cloth (see Japanese Patent Laid-Open Publication No. 2007-115886).

The applicant has proposed a method which uses a fluid blowing mechanism for blowing a gas, such as a compressed gas, toward a polishing surface and which involves controlling the fluid blowing mechanism, based on the results of measurement of the distribution of the temperature of the polishing surface, so that the polishing surface is brought into a predetermined temperature distribution (see Japanese Patent Laid-Open Publication No. 2007-181910).

### SUMMARY OF THE INVENTION

However, it has been generally difficult to carry out polishing of a surface (surface to be polished) of a substrate at a sufficient polishing rate and to obtain a desired polishing profile without leaving an unpolished portion on the surface of the substrate after polishing. For example, when a copper film formed on a surface of a substrate is polished while controlling the temperature of a polishing pad at a constant temperature in order to obtain a sufficient polishing rate, the copper film will not be completely polished away. Thus, a considerable amount of unpolished copper film may remain in a scattered state on the surface of the substrate after polishing.

The present invention has been made in view of the above situation. It is therefore an object of the present invention to provide a polishing method and apparatus which makes it possible to polish a surface (surface to be polished) of a substrate at a sufficient polishing rate and obtain a desired polishing profile while preventing an unpolished portion from remaining on the surface of the substrate after polishing.

In order to achieve the above object, the present invention provides a polishing method for polishing a surface to be polished with a polishing pad while controlling the temperature of the polishing pad by blowing a gas toward the polishing pad. The polishing method comprises monitoring the polishing state of the surface to be polished during polishing while PID-controlling the flow rate or the blow direction of the gas, and changing the control temperature of the polishing pad when a predetermined thickness of a film to be polished is reached.

The polishing state of the surface to be polished is the thickness of a film to be polished, for example. In a preferred aspect of the present invention, the temperature of the polishing pad is controlled so that the maximum polishing rate can be achieved before a predetermined thickness of a film to be polished is reached, for example, before a film thickness, at which surface irregularities of the surface to be polished are removed, is reached and, after the predetermined film thickness is reached, the temperature of the polishing pad is controlled so that surface irregularities of the surface to be polished, the number of defects or the amount of unpolished metal can be minimized. This can prevent an unpolished portion from remaining in a scattered state on the surface to be polished after polishing without entailing a significant lowering of the polishing rate.

Preferably, a dry gas is used as the gas before the predetermined film thickness is reached, and a mist is used as the gas after the predetermined film thickness is reached.

The dry gas may be supplied to the polishing pad by blowing compressed air as the dry gas toward the polishing pad from a cooling nozzle, or by blowing air as the dry gas toward the polishing pad by rotating a cooling fan. The use of a mist to control the temperature of the polishing pad can increase the effect of cooling the polishing pad.

Preferably, polishing is carried out at a first polishing pressure before the predetermined film thickness is reached and, after the predetermined film thickness is reached, polishing is carried out at a second polishing pressure which is lower than the first polishing pressure.

This manner of polishing can increase the polishing rate during the polishing before the predetermined film thickness is reached.

The monitoring of the surface to be polished during polishing may be performed by using an eddy current sensor, an optical sensor or a torque current sensor.

The present invention provides another polishing method for polishing a surface to be polished with a polishing pad while controlling the temperature of the polishing pad by blowing a gas toward the polishing pad. The polishing method comprises: a first polishing step of polishing the surface to be polished while controlling the temperature of the polishing pad at a temperature corresponding to that elastic modulus of the polishing pad which achieves the maximum polishing rate, based on data on a correlation between the elastic modulus of the polishing pad and the temperature of the polishing pad as well as data on a correlation between the elastic modulus of the polishing pad and the polishing rate or data on a correlation between the elastic modulus of the polishing pad and at least one of planarities, the number of defects and the amount of unpolished metal; and a second polishing step of polishing the surface to be polished while controlling, based on the correlation data, the temperature of the polishing pad at a temperature corresponding to that elastic modulus of the polishing pad which achieves desired planarities.

The present invention provides yet another polishing method for polishing a surface to be polished with a polishing pad while controlling the temperature of the polishing pad by blowing a gas toward the polishing pad. The polishing method comprises monitoring the polishing state of the surface to be polished during polishing and, when a predetermined thickness of a film to be polished is reached, predicting a polishing end time, and controlling the blowing of the gas so that the temperature of the polishing pad reaches a predetermined temperature at the polishing end time.

The present invention also provides a polishing apparatus for polishing a substrate comprising: a gas blow section for blowing a gas toward a polishing pad to control the temperature of the polishing pad; a controller for PID-controlling the flow rate or the blow direction of the gas blowing from the gas blow section; and a monitor for monitoring the polishing state of a surface to be polished. A recipe, which indicates a relationship between the control temperature of the polishing pad and the thickness of a film to be polished, is stored in the controller, and the controller and the monitor are configured to operate based on the recipe and change the control temperature of the polishing pad according to the thickness of the film.

Preferable, the polishing apparatus further comprises a cleaning tool for cleaning the gas blow section.

The cleaning tool can clean the gas blow section to remove dirt, such as a slurry, from the gas blow section, thereby preventing the dirt, adhering to the gas blow section, from adversely affecting the next substrate.

Preferably, the cooling device is comprised of at least one of a cooling nozzle for blowing compressed air as the dry gas toward the polishing pad and a cooling fan for blowing air as the dry gas toward the polishing pad.

Preferably, the polishing apparatus may further comprises a temperature sensor for detecting the temperature of the polishing pad, and a temperature controller for controlling, based on a detection value of the temperature sensor, an amount of the dry gas to be supplied from the gas blow section to the polishing pad.

The present invention also provides a method for polishing a substrate by bringing the substrate into sliding contact with a polishing pad. The method comprises: rotating a polishing table holding the polishing pad; pressing a surface of the substrate against the polishing pad; supplying a slurry to the polishing pad; blowing a gas toward the polishing pad while controlling a flow rate or a blow direction of the gas by PID-control so that a temperature of the polishing pad becomes a first control temperature; monitoring a polishing state of the substrate; and blowing a gas toward the polishing pad while controlling a flow rate or a blow direction of the gas by PID-control so that a temperature of the polishing pad becomes a second control temperature after the polishing state is detected to be a predetermined state.

The present invention makes it possible to polish a surface (surface to be polished) of a substrate at a sufficient polishing rate and obtain a desired polishing profile while preventing an unpolished portion from remaining on the surface of the substrate after polishing.

### BRIEF DESCRIPTION OF THE DRAWINGS

FIG. 1 is a schematic view of a polishing apparatus according to an embodiment of the present invention;
FIG. 2 is an enlarged view of a cooling nozzle and its vicinity in the polishing apparatus shown in FIG. 1;
FIG. 3 is a diagram showing a polishing head and head cleaning nozzles, provided in the polishing apparatus shown in FIG. 1;
FIG. 4 is a schematic view of a slurry supply nozzle with a windshield plate attached thereto;
FIG. 5 is a schematic view of a polishing apparatus according to another embodiment of the present invention;
FIG. 6 is a schematic plan view of a polishing apparatus according to yet another embodiment of the present invention;
FIG. 7 is a graph showing an exemplary relationship between the temperature of a polishing pad and polishing rate;
FIG. 8 is a cross-sectional diagram showing an exemplary substrate to be polished by a polishing apparatus according to the present invention; and
FIG. 9 is a cross-sectional diagram showing another exemplary substrate to be polished by a polishing apparatus according to the present invention.

### DETAILED DESCRIPTION OF THE PREFERRED EMBODIMENTS

Preferred embodiments of the present invention will now be described with reference to the drawings. The same reference numerals will be used throughout the drawings and the description to refer to the same or like members, components, etc., and a duplicate description thereof will be omitted.

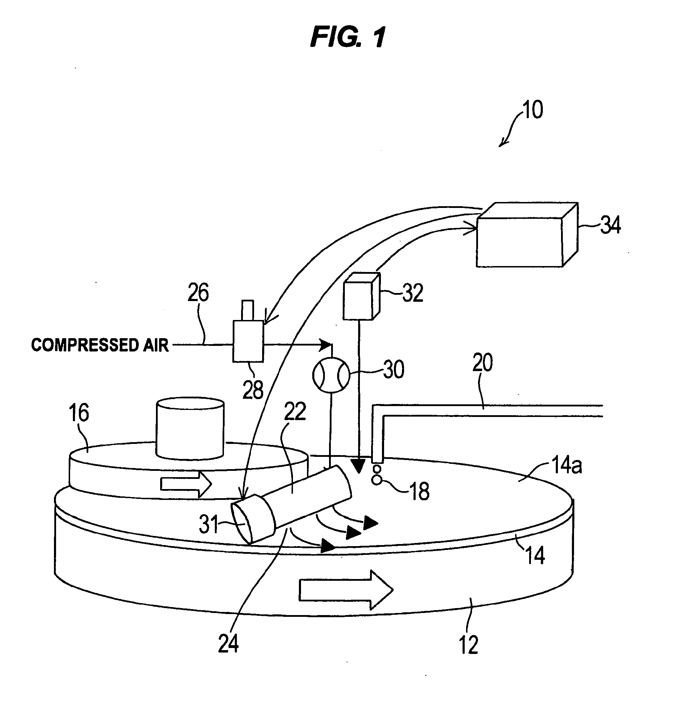

FIG. 1 schematically shows the overall construction of a polishing apparatus according to an embodiment of the present invention. As shown in FIG. 1, the polishing apparatus 10 includes a rotatable polishing table 12, a polishing pad 14 attached to an upper surface of the polishing table 12 and whose upper surface serves as a polishing surface 14a, a polishing head 16 as a substrate holding mechanism for holding a substrate, such as a semiconductor wafer, and pressing the substrate against the polishing surface 14a, and a slurry supply nozzle 20, disposed above the polishing pad 14, for supplying a slurry 18 to the polishing pad 14. This polishing apparatus 10 is configured to polish a surface (surface to be polished) of a substrate (not shown) by pressing the surface of the substrate against the polishing surface 14a of the polishing pad 14 while rotating the polishing table 12 and the polishing head 16, holding the substrate on the lower surface, to move the substrate and the polishing surface 14a of the polishing pad 14 relative to each other and supplying the slurry 18 as a polishing liquid from the slurry supply nozzle 20 to the polishing pad 14.

The elastic modulus of the polishing pad 14 used in this embodiment changes from 10 GPa to 10 MPa in the temperature range of 0°C to 80°C. A resin polishing pad, for example, generally increases its hardness when it is cooled, and therefore improves the planarities by cooling the polishing pad. Thus, it is possible to predetermine, for a film to be polished, the relationship between the temperature of a polishing pad and the elastic modulus of the polishing pad as well as the relationship between the elastic modulus of the polishing pad and the planarities, the number of defects, the amount of unpolished metal (film) or the polishing rate, and to set the optimum elastic modulus of the polishing pad for the film to be polished (for the corresponding polishing step) and for the intended purpose of the polishing. Polishing of the intended film can be performed while controlling the elastic modulus of the polishing pad by adjusting the temperature of the polishing pad according to the progress of polishing.

The polishing head 16 is coupled to a free end of a not-shown vertically movable pivot arm and configured to move horizontally between a polishing position above the polishing table 12 and a substrate transfer position where a substrate is transferred to and from, e.g., a pusher of a linear transporter.

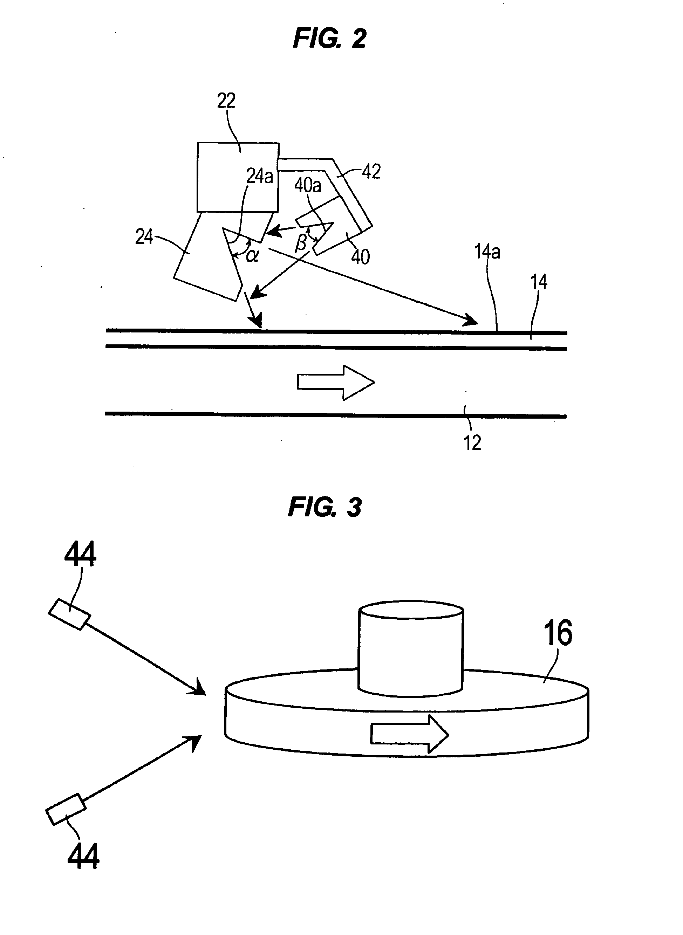

Above the polishing pad 14 is disposed a nozzle support arm 22 which extends parallel to the polishing surface 14a of the polishing pad 14 approximately in the radial direction of the polishing pad 14. As shown in FIG. 2, to the bottom of the nozzle support arm 22 are mounted cooling nozzles 24 as a cooling device, which communicate with the interior of the nozzle support arm 22 and cool the polishing pad 14 by blowing compressed air as a dry gas toward the polishing pad 14. Each cooling nozzle 24 has a nozzle opening 24a with a predetermined opening angle α so that compressed air can be blown toward the entire substrate passage area of the polishing surface 14a to make the temperature of that area uniform. The number, the positions, etc. of the cooling nozzles 24 can be arbitrarily set depending on the process conditions, etc.

The nozzle support arm 22 is connected to a compressed air supply line 26 extending from a compressed air supply source. A pressure control valve 28 and a flow meter 30 are interposed in the compressed air supply line 26. Thus, the pressure of compressed air (dry gas) is controlled when it passes through the pressure control valve 28 and the flow rate of the compressed air is measured when it passes through the flow meter 30. After passing though the pressure control valve 28 and the flow meter 30, compressed air flows into the nozzle support arm 22 and is blown toward the polishing pad 14 from the openings 24a of the cooling nozzles 24. The nozzle support arm 22 is rotatable about its own axis by a servomotor 31. The blow direction of compressed air (dry gas), blown from the nozzle openings 24a of the cooling nozzles 24, can be adjusted by rotating the nozzle support arm 22.

Above the polishing pad 14 is disposed a thermometer 32, e.g., a radiation thermometer, for detecting the temperature of the polishing pad 14. The thermometer 32 is connected to a temperature controller 34 for setting a target temperature (i.e., control temperature) of the polishing pad 14. The temperature controller 34 is connected to the pressure control valve 28 and the servomotor 31, so that the pressure control valve 28 and the servomotor 31 can be PID-controlled by an output signal from the temperature controller 34.

In particular, a plurality of PID parameters are stored in the temperature controller 34. Based on a difference between a set temperature (i.e., control temperature) of the polishing pad 14, set in the temperature controller 34, and the actual temperature of the polishing pad 14 detected by the thermometer 32, a particular PID parameter is selected from the plurality of PID parameters and, based on information on the temperature of the polishing pad 14 detected by the thermometer 32, the valve position of the pressure control valve 28 and the rotation angle of the servomotor 31 are controlled by an electropneumatic regulator (not shown) so that the polishing pad 14 becomes a predetermined temperature (i.e., control temperature). The valve position of the pressure control valve 28 is controlled so that the flow rate of compressed air, blown from the cooling nozzles 24 toward the polishing pad 14, becomes 50 to 1000 L/min, for example. It is possible to set at least one predetermined PID parameter in advance.

The nozzle support arm 22 rotates by the rotation of the servomotor 31. The rotation angle of the servomotor 31 is PID-controlled such that the blow direction of compressed air (dry gas), blown from the nozzle openings 24a of the cooling nozzles 24, can be adjusted. For example, when the actual temperature of the polishing pad 14 is higher than a target temperature, the rotation angle of the servomotor 31 is PID-controlled so that the angle of the blow direction of compressed air (dry gas), blown from the nozzle openings 24a of the cooling nozzles 24, with respect to the plane of the polishing pad 14 becomes larger and the cooling effect increases. In contrast, when the actual temperature of the polishing pad 14 is lower than a target temperature, the rotation angle of the servomotor 31 is PID-controlled so that the angle of the blow direction of compressed air with respect to the plane of the polishing pad 14 becomes smaller and the cooling effect decreases.

Though in this embodiment both the valve position of the pressure control valve 28 and the rotation angle of the servomotor 31 are PID-controlled, it is possible to PID-control only one of the valve position of the pressure control valve 28 and the rotation angle of the servomotor 31. This holds true for the below-described embodiments. The servomotor 31 is omitted in the below-described embodiments.

As shown in FIG. 2, cleaning nozzles 40 as a cleaning tool for cleaning the cooling nozzles 24 by spraying a cleaning liquid onto the cooling nozzles 24 are mounted to the nozzle support arm 22 via a bracket 42. Each of the cleaning nozzles (cleaning tool) 40 has a nozzle opening 40a with a predetermined opening angle β so that the cleaning liquid can be sprayed onto the entire area of the nozzle opening 24a and its vicinity of each cooling nozzle 24. Thus, the entire area of the nozzle opening 24a and its vicinity of each cooling nozzle 24 is mainly cleaned with the cleaning liquid sprayed from each cleaning nozzle 40.

As shown in FIG. 3, beside the polishing head 16 are provided two cleaning nozzles 44, disposed above and below the polishing head 16, for cleaning the polishing head 16 by jetting a cleaning liquid toward the peripheral end surface of the polishing head 16 from above and below. When compressed air is blown from the cooling nozzles 24 toward the polishing pad 14, the slurry 18, which has been supplied onto the polishing pad 14, is blown away by the compressed air and adheres to the peripheral end surface of the polishing head 16. According to this embodiment, the slurry adhering to the peripheral end surface of the polishing head 16 can be removed by jetting the cleaning liquid from the head cleaning nozzles 44 toward the peripheral end surface of the polishing head 16.

Though not shown diagrammatically, the polishing apparatus is provided with a torque current monitor for monitoring the torque or current of the polishing table 12 to monitor the polishing state of a film to be polished, such as the thickness of the film. Instead of the torque current monitor for monitoring the torque or current of the polishing table 12, it is possible to use a torque current monitor for monitoring the torque or current of the polishing head 16. It is also possible to monitor the polishing state of a film to be polished, such as the thickness of the film, with an eddy current sensor or an optical sensor.

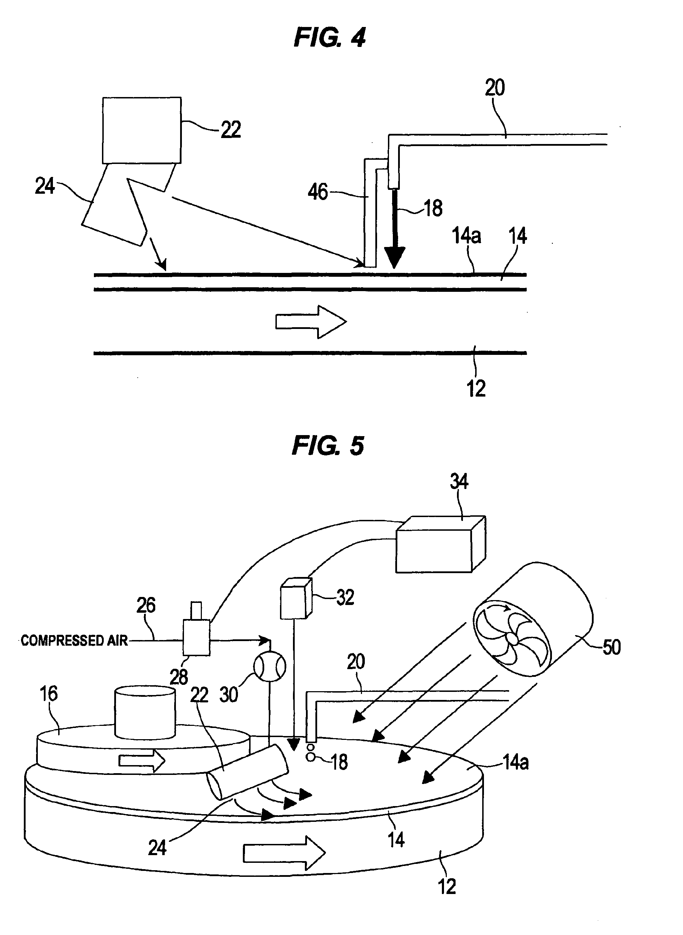

As shown in FIG. 4, it is preferred to provide a windshield plate 46 between the cooling nozzles 24 and the slurry supply nozzle 20. This can prevent variation from being produced in the distribution of the slurry 18 to be supplied onto the polishing pad 14 from the slurry supply nozzle 20, due to the influence of compressed air blown toward the polishing pad 14 from the cooling nozzles 24, thereby preventing variation in the polishing performance.

FIG. 5 schematically shows the overall construction of a polishing apparatus according to another embodiment of the present invention. This embodiment differs from the embodiment shown in FIGS. 1 through 3 in that a cooling fan 50 as a cooling device for blowing air as a dry gas toward the polishing pad 14 is disposed above the polishing table 12 so that the polishing pad 14 can be further cooled by the air blown from the cooling fan 50.

The provision of the cooling fan 50 in addition to the cooling nozzles 24 can increase the effect of cooling the polishing pad 14. It is also possible to provide only the cooling fan 50.

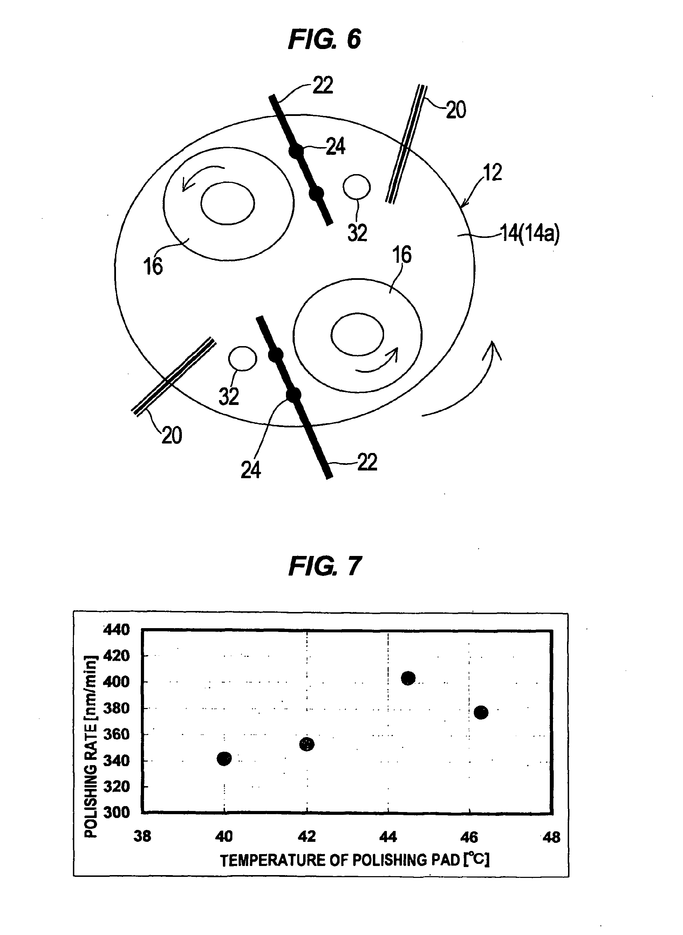

FIG. 6 is a schematic plan view of a polishing apparatus according to yet another embodiment of the present invention. The polishing apparatus of this embodiment is configured to be capable of simultaneously polishing two substrates on one polishing table 12. The polishing apparatus of this embodiment includes the polishing table 12 with a polishing pad 14 attached to the upper surface, and two polishing heads 16. Positioned above the polishing pad 14 are disposed two sets of a nozzle support arm 22 provided with cooling nozzles 24, a thermometer 32 and a slurry supply nozzle 20, arranged in this order along a direction opposite to the direction of rotation of the polishing table 12. The polishing pad 14 is brought into contact with the surfaces (to be polished) of two substrates, held by the polishing heads 16, after a slurry 18 begins to be supplied from the slurry supply nozzles 20, the temperature of the polishing pad 14 is measured with the thermometers 32 and the polishing pad 14 begins to be cooled by compressed air blown from the cooling nozzles 24. The positional relationship between the nozzle support arm 22 provided with the cooling nozzles 24, the thermometer 32 and the slurry supply nozzle 20 in each set is, of course, not limited to that of this embodiment.

FIG. 7 shows an exemplary relationship between the temperature of a polishing pad and polishing rate. As can be seen in FIG. 7, there exists a specific temperature (fastest polishing temperature) that gives the maximum polishing rate: the polishing rate decreases from the maximum polishing rate with decrease or increase in the temperature of the polishing pad from the fastest polishing temperature.

Polishing of a surface (surface to be polished) of a substrate by the polishing apparatus shown in FIGS. 1 through 3 will now be described in the following three exemplary cases.

### [Case 1]

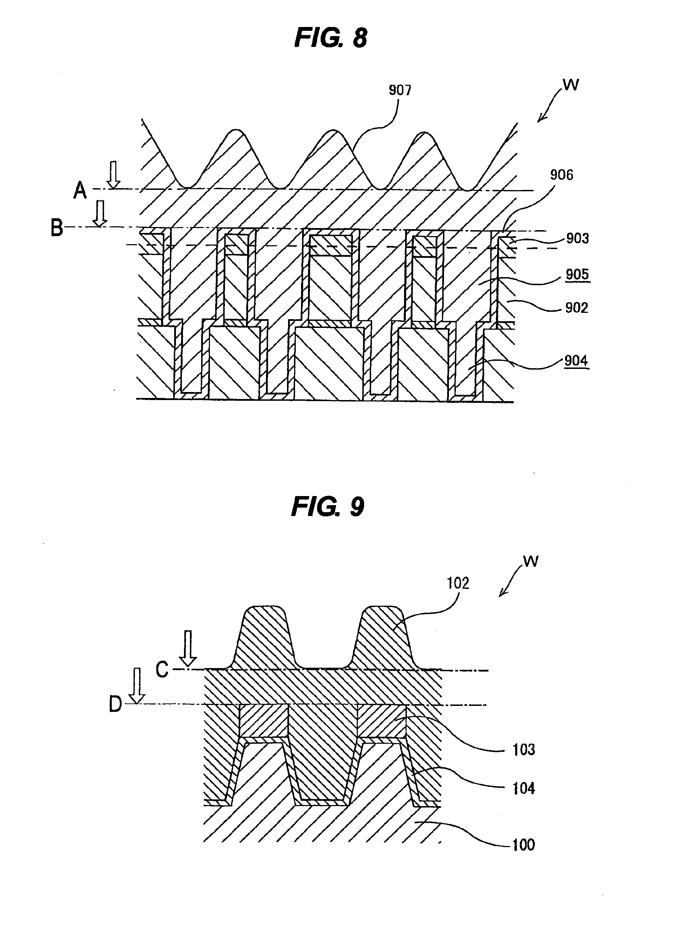

A substrate W is prepared which, as shown in FIG. 8, has insulating films 902, 903 having via holes 904 and trenches 905, a barrier film 906 formed on the insulating films 902, 903, and a metal film 907 formed on the barrier film 906. Those portions of the metal film 907, which are embedded in the via holes 904 and the trenches 905, constitute metal interconnects. In the case 1, the metal film is a copper film and the metal interconnects are copper interconnects.

First, the supply pressure of compressed air to be supplied to the cooling nozzles 24 is confirmed. If this supply pressure is less than a specified pressure, a warning is issued and processing of subsequent substrates is stopped. When this supply pressure is not less than a specified pressure, the polishing head 16 in the substrate transfer position receives a substrate W, e.g., from a pusher and holds the substrate W by attraction. The substrate W held by the polishing head 16 is then moved horizontally from the substrate transfer position to the polishing position just above the polishing table 12.

Next, monitoring of the temperature of the polishing pad 14 with the thermometer 32 is started. Even when the temperature of the polishing pad 14 is then more than a set temperature, blowing of compressed air from the cooling nozzles 24 toward the polishing pad 14 is not started in order to prevent compressed air from directly hitting the substrate W, held by the polishing head 16, before contact with the polishing head 14.

While supplying a slurry 18 from the slurry supply nozzle 20 to the polishing pad 14, the polishing head 16 is rotated and lowered to bring the surface (surface to be polished) of the substrate W, held by the polishing head 16, into contact with the polishing surface 14a of the polishing pad 14 on the rotating polishing table 12. Thereafter, the substrate W is released from the attraction to the polishing head 16, and the surface of the substrate W is pressed against the polishing surface 14a at a first polishing pressure. Polishing of the metal film (copper film) 907 shown in FIG. 8 is thus started (first polishing step).

In the first polishing step, control of the temperature of the polishing pad 14 with the cooling nozzles 24 is started when the substrate W comes into contact with the polishing surface 14a. When a method is used in which the substrate W is brought into contact with the polishing surface 14a without rotating the polishing table 12, control of the temperature of the polishing pad 14 with the cooling nozzle 24 is started simultaneously with the start of rotation of the polishing table 12.

In particular, based on a difference between a set temperature of the polishing pad 14 and the actual temperature, the flow rate and the blow direction of compressed air, blown from the cooling nozzles 24 toward the polishing pad 14, are PID-controlled to control the temperature of the polishing pad 14 at a predetermined first temperature which can achieve the maximum polishing rate. The first polishing step is intended to shorten the total polishing time by using a high polishing pressure in combination with the cooling of the polishing pad 14. The control temperature of the polishing pad 14 is set, e.g., at 50°C. The temperature of the polishing pad 14, if not cooled, would rise up to, e.g. , 60°C. The first polishing step is terminated when surface irregularities of the metal film (copper film) 907 have been removed, as shown by the imaginary line A in FIG. 8, and the barrier film 906, underlying the metal film 907, begins to be exposed, for example, when the torque current monitor detects that a predetermined thickness of the metal film (copper film) 907, e.g., 100 nm to 300 nm, is reached.

Next, based on a difference between a set temperature of the polishing pad 14 and the actual temperature, the flow rate and the blow direction of compressed air, blown from the cooling nozzles 24 toward the polishing pad 14, are PID-controlled to control the temperature of the polishing pad 14 at a predetermined second temperature which can achieve best planarities of the surface of the substrate or can achieve the minimum number of defects or the minimum amount of unpolished film, and polishing is continued while thus controlling the temperature of the polishing pad 14 (second polishing step). In the second polishing step, mainly in order to improve the planarities, polishing may be carried out in a low-pressure polishing manner by pressing the surface of the substrate W against the polishing surface 14a at a second polishing pressure which is lower than the first polishing pressure, as necessary. Furthermore, the maximum possible cooling of the polishing pad 14 may be performed, e.g., at a set temperature of 0°C. The second polishing step is terminated when the torque current monitor detects that the extra metal film (copper film) 907 lying outside the trenches 905 has been polished away and the surface of the underlying barrier film 906 has become completely exposed, as shown by the imaginary line B in FIG. 8.

The temperature of the polishing pad 14 may be controlled in such a manner that a desired temperature is reached at the time when the surface of the barrier film 906 has become completely exposed. In an exemplary method, the end of the first polishing step is detected by in-situ monitoring of the polishing state (the polishing rate, the polishing amount, the thickness of the remaining film, etc.) and, after the polishing is shifted to the second polishing step, the remaining polishing time until the end of polishing is calculated from monitored values. The temperature of the polishing pad 14 is then controlled so that the current temperature of the polishing pad 14 gradually changes and reaches a desired temperature after the remaining polishing time. This can reduce the influence of the rapid temperature change in the polishing pad 14 on the polishing.

The first polishing step is shifted to the second polishing step when the film thickness detected, e.g., by an eddy current sensor or an optical sensor has reached a target thickness. The film thickness at the start of the second polishing step is thus known. Further, the polishing rate in the second step can be determined by monitoring change with time in the thickness of the remaining film for an appropriate amount of time (about a few seconds) and differentiating the change. The remaining polishing time can be determined from the polishing rate and the thickness of the remaining film.

In order to make the temperature of the polishing pad 14 into a predetermined temperature after a predetermined amount of time, it is necessary to prepare a software program which dose not make the PID-control temperature constant but enables input of a target temperature which changes with time. For example, the program is designed to enable input of target temperatures at the start and the end of the second polishing step. On the other hand, the remaining polishing time can be determined as described above. Once the temperatures at the start and the end of the second polishing step and the time from the start to the end of the second polishing step are known, a linear relationship between the temperature and time can be easily calculated. Therefore, by designing the program to have the function of changing with time a PID target temperature according to the calculated relationship, the polishing pad 14 can be brought into a predetermined temperature after a predetermined amount of time. The number of PID target temperatures, which vary with time, and the time intervals between them can be set arbitrarily.

After stopping the blowing of compressed air from the cooling nozzles 24 and stopping the supply of the slurry from the slurry supply nozzle 20, water polishing of the substrate W is carried out by supplying pure water to the polishing pad 14.

While continuing the stoppage of blowing of compressed air from the cooling nozzles 24 so as to prevent compressed air from hitting the substrate W, the polishing head 16 attracts the substrate W after polishing and detaches it from the polishing surface 14a. The stoppage of blowing of compressed air from the cooling nozzle 24 is continued while the substrate W lies above the polishing table 12 in order to prevent compressed air from hitting and drying the surface of the substrate W lying above the polishing table 12.

Next, the polishing head 16 holding the substrate W is raised and then moved horizontally from the polishing position to the substrate transfer position, where the substrate W after polishing is transferred to, e.g., a pusher.

On the other hand, self-cleaning of the cooling nozzles 24 is carried out by spraying a cleaning liquid (water) from the cleaning nozzles 40 onto the cooling nozzles 24, in particular the nozzle openings 24a and their vicinity. During the self-cleaning, the cleaning liquid may be caused to flow rapidly on the polishing table 12 so as to prevent dirt, such as the slurry, that has fallen off the cooling nozzles 24 onto the polishing table 12 from remaining on the polishing table 12 (polishing surface 14a) and adversely affecting processing of the next substrate.

It is possible to design the nozzle support arm 22 to be movable to a stand-by position beside the polishing table 12, and to carry out cleaning of the cooling nozzles 24 by the cleaning nozzles 40 at the stand-by position. This can prevent dirt such as the slurry, attached to the cooling nozzles 24, from falling onto the polishing table 12.

After the substrate W leaves the polishing head by moving horizontally 16 and is transferred, e.g., to a pusher, a cleaning liquid (water) is blown from the head cleaning nozzles 44 toward the peripheral end surface of the polishing head 16 to clean off dirt, such as the slurry, adhering to the peripheral end surface of the polishing head 16.

In the case 1, both the flow rate and the blow direction of compressed air, blown from the cooling nozzles 24 toward the polishing pad 14, are PID-controlled. It is possible to PID-control only one of the flow rate and the blow direction of compressed air. This holds true for the below-described cases 2 and 3.

### [Case 2]

A substrate W as shown in FIG. 8, which is similar to the substrate W of the above-described case 1, is prepared. In the case 2, the metal film 907 is a tungsten film and the metal interconnects are tungsten interconnects.

First, as with the above-described case 1, the supply pressure of compressed air, to be supplied to the cooling nozzles 24, is confirmed. When this supply pressure is not less than a specified pressure, the polishing head 16 in the substrate transfer position receives a substrate W, e.g. , from a pusher and holds the substrate W by attraction. The substrate W held by the polishing head 16 is then moved horizontally from the substrate transfer position to the polishing position just above the polishing table 12.

Next, monitoring of the temperature of the polishing pad 14 with the thermometer 32 is started. As with the case 1, blowing of compressed air from the cooling nozzles 24 toward the polishing pad 14 is not yet started.

While supplying a slurry 18 from the slurry supply nozzle 20 to the polishing pad 14, the polishing head 16 is rotated and lowered to bring the surface (surface to be polished) of the substrate W, held by the polishing head 16, into contact with the polishing surface 14a of the polishing pad 14 on the rotating polishing table 12. Thereafter, the substrate W is released from the attraction to the polishing head 16, and the surface of the substrate W is pressed against the polishing surface 14a at a first polishing pressure. Polishing of the metal film (tungsten film) 907, shown in FIG. 8, is thus started (first polishing step).

In the first polishing step, control of the temperature of the polishing pad 14 with the cooling nozzle 24 is started when the substrate W comes into contact with the polishing surface 14a. When a method is used in which the substrate W is brought into contact with the polishing surface 14a without rotating the polishing table 12, control of the temperature of the polishing pad 14 with the cooling nozzle 24 is started simultaneously with the start of rotation of the polishing table 12.

In particular, based on a difference between a set temperature of the polishing pad 14 and the actual temperature, the flow rate and the blow direction of compressed air, blown from the cooling nozzles 24 toward the polishing pad 14, are PID-controlled to control the temperature of the polishing pad 14 at a predetermined first temperature which can achieve the maximum polishing rate. The first polishing step is intended to shorten the total polishing time by using a high polishing pressure in combination with the cooling of the polishing pad 14. The control temperature of the polishing pad 14 is set, e.g., at 0°C and the maximum possible cooling of the polishing pad 14 is performed. The temperature of the polishing pad 14, if not cooled, would rise up to, e.g., 70°C. The first polishing step is terminated when surface irregularities of the metal film (tungsten film) 907 have been removed, as shown by the imaginary line A in FIG. 8, and the barrier film 906, underlying the metal film 907, begins to be exposed, for example, when the torque current monitor detects that a predetermined thickness of the metal film (tungsten film) 907, e.g., 100 nm to 300 nm, is reached.

Next, based on a difference between a set temperature of the polishing pad 14 and the actual temperature, the flow rate and the blow direction of compressed air, blown from the cooling nozzles 24 toward the polishing pad 14, are PID-controlled to control the temperature of the polishing pad 14 at a predetermined second temperature which can best remove surface irregularities or can achieve the minimum number of defects or the minimum amount of unpolished film, and polishing is continued while thus controlling the temperature of the polishing pad 14 (second polishing step). In the second polishing step, mainly in order to improve the planarities, polishing may be carried out in a low-pressure polishing manner by pressing the surface of the substrate W against the polishing surface 14a at a second polishing pressure which is lower than the first polishing pressure, as necessary. Furthermore, the maximum possible cooling of the polishing pad 14 may be performed, e.g., at a set temperature of 0°C. The second polishing step is terminated when the torque current monitor detects that the extra metal film (tungsten film) 907 lying outside the trenches 905 has been polished away and the surface of the underlying barrier film 906 has become completely exposed, as shown by the imaginary line B in FIG. 8.

The subsequent operations are the same as in the above-described case 1.

### [Case 3]

The case 3 is applicable to an STI (shallow trench isolation) process, a polysilicon removal process, a barrier layer removal process, etc. In the case of an STI process, for example, a substrate W, as shown in FIG. 9, is prepared. The substrate W comprises a silicon wafer 100 having trenches, a pad oxide film 104 which covers the surface of the silicon wafer 100, an SiN film 103 formed on the pad oxide film 104 and lying outside the trenches, and an SiO₂ film 102 of a insulating film which fills the trenches of the silicon wafer 100 and covers an entire surface of the substrate W.

First, as with the above-described case 1, the supply pressure of compressed air, to be supplied to the cooling nozzle 24, is confirmed. When this supply pressure is not less than a specified pressure, the polishing head 16 in the substrate transfer position receives a substrate W, e.g., from a pusher and holds the substrate W by attraction. The substrate W held by the polishing head 16 is then moved horizontally from the substrate transfer position to the polishing position just above the polishing table 12.

Next, monitoring of the temperature of the polishing pad 14 with the thermometer 32 is started. As with the case 1, blowing of compressed air from the cooling nozzles 24 toward the polishing pad 14 is not yet started.

While supplying a slurry 18 from the slurry supply nozzle 20 to the polishing pad 14, the polishing head 16 is rotated and lowered to bring the surface (surface to be polished) of the substrate W, held by the polishing head 16, into contact with the polishing surface 14a of the polishing pad 14 on the rotating polishing table 12. Thereafter, the substrate W is released from the attraction to the polishing head 16, and the surface of the substrate W is pressed against the polishing surface 14a at a first polishing pressure. Polishing of the SiO₂ film (insulating film) 102 shown in FIG. 9 is thus started (first polishing step).

In the first polishing step, control of the temperature of the polishing pad 14 with the cooling nozzles 24 is started when the substrate W comes into contact with the polishing surface 14a. When a method is used in which the substrate W is brought into contact with the polishing surface 14a without rotating the polishing table 12, control of the temperature of the polishing pad 14 with the cooling nozzles 24 is started simultaneously with the start of rotation of the polishing table 12.

In particular, based on a difference between a set temperature of the polishing pad 14 and the actual temperature, the flow rate and the blow direction of compressed air, blown from the cooling nozzles 24 toward the polishing pad 14, are PID-controlled to control the temperature of the polishing pad 14 at a predetermined first temperature which can achieve the maximum polishing rate. The first polishing step is intended to shorten the total polishing time by using a high polishing pressure in combination with the cooling of the polishing pad 14. The control temperature of the polishing pad 14 is set, e.g., at 50°C. The temperature of the polishing pad 14, if not cooled, would rise up to, e.g., 60°C. The first polishing step is terminated when the torque current monitor detects that surface irregularities of the SiO₂ film 102 have been removed, as shown by the imaginary line C in FIG. 9.

Next, based on a difference between a set temperature of the polishing pad 14 and the actual temperature, the flow rate and the blow direction of compressed air, blown from the cooling nozzles 24 toward the polishing pad 14, are PID-controlled to control the temperature of the polishing pad 14 at a predetermined second temperature which can best remove surface irregularities, and polishing is continued while thus controlling the temperature of the polishing pad 14(second polishing step). In the second polishing step, a low additive flow rate is used to increase the polishing rate for the SiO₂ film 102. Furthermore, the maximum possible cooling of the polishing pad 14 may be performed, e.g., at a set temperature of 0°C to improve the planarities.

The cooling of the polishing pad 14 in the second polishing step may decrease the polishing rate. However, a prolonged total polishing time can be avoided by the use of a low additive flow rate which can increase the polishing rate. The second polishing step is terminated when the torque current monitor detects that the extra SiO₂ film 102 lying outside the trenches has been polished away and the surface of the underlying SiN film 103 has become completely exposed, as shown by the imaginary line D in FIG. 9.

The subsequent operations are the same as in the case 1.

Though in the above-described embodiments the temperature of the polishing pad 14 is adjusted in the second polishing step by supplying a dry gas, such as compressed air, to the polishing pad 14, it is also possible to adjust the temperature of the polishing pad 14 by supplying a mist to the polishing pad 14. The use of a mist for the adjustment of the temperature of the polishing pad 14 can increase the effect of cooling the polishing pad 14.

Though in the above-described embodiments PID control is used for the adjustment of the temperature of the polishing pad 14 in the second polishing step, it is also possible to perform the maximum possible cooling of the polishing pad 14 without using PID control, e.g., by maximizing the valve position of an electropneumatic regulator which may be PID-controlled in the first polishing step.

Though in the above-described embodiments the temperature of the polishing pad 14 is controlled (cooled) in the first polishing step, it is possible to carry out the first polishing step without controlling (cooling) the temperature of the polishing pad 14, and to cool the polishing pad 14 to below a predetermined temperature in the second polishing step.

Depending on the type of a slurry used, which is supplied to a polishing pad during polishing, there are cases where the temperature of the polishing pad increases during polishing and, after a certain temperature is reached, the temperature of the polishing pad spontaneously decreases. In such a case, it is possible to start polishing without performing temperature adjustment for the polishing pad, and start cooling of the polishing pad when a predetermined thickness of a film to be polished is reached. This manner can effectively prevent an unpolished portion of the film from remaining in a scattered state on a surface of an underlying layer without entailing a significant lowering of the polishing rate.

Though in the above-described embodiments the control (cooling) temperature of the polishing pad 14 is changed between the first polishing step and the second polishing step, it is also possible to cool the polishing pad 14 such that the temperature of the polishing pad 14 is kept constant throughout the first and second polishing steps. For example, a target control temperature in the second polishing step may be set also in the first polishing step. This may lead to a lowering of the polishing rate in the first polishing rate. However, the efficiency of polishing in the second polishing step can be increased because of no time lag of the polishing pad temperature associated with change of pad control temperature.

While the present invention has been described with reference to preferred embodiments, it is understood that the present invention is not limited to the embodiments described above, but is capable of various changes and modifications within the scope of the inventive concept as expressed herein.

## Claims

1. A polishing method for polishing a surface to be polished with a polishing pad while controlling the temperature of the polishing pad by blowing a gas toward the polishing pad, said method comprising:
monitoring the polishing state of the surface to be polished during polishing while PID-controlling the flow rate or the blow direction of the gas; and
changing the control temperature of the polishing pad when a predetermined thickness of a film to be polished is reached.

2. The polishing method according to claim 1, wherein a dry gas is used as the gas before the predetermined film thickness is reached, and a mist is used as the gas after the predetermined film thickness is reached.

3. The polishing method according to claim 1, wherein polishing is carried out at a first polishing pressure before the predetermined film thickness is reached and, after the predetermined film thickness is reached, polishing is carried out at a second polishing pressure which is lower than the first polishing pressure.

4. The polishing method according to claim 1, wherein the monitoring of the surface to be polished during polishing is performed by using an eddy current sensor, an optical sensor or a torque current sensor.

5. A polishing method for polishing a surface to be polished with a polishing pad while controlling the temperature of the polishing pad by blowing a gas toward the polishing pad, said method comprising:
a first polishing step of polishing the surface to be polished while controlling the temperature of the polishing pad at a temperature corresponding to that elastic modulus of the polishing pad which achieves the maximum polishing rate, based on data on a correlation between the elastic modulus of the polishing pad and the temperature of the polishing pad as well as data on a correlation between the elastic modulus of the polishing pad and the polishing rate or data on a correlation between the elastic modulus of the polishing pad and at least one of the planarities, the number of defects and the amount of unpolished metal; and
a second polishing step of polishing the surface to be polished while controlling, based on the correlation data, the temperature of the polishing pad at a temperature corresponding to that elastic modulus of the polishing pad which achieves desired planarities.

6. A polishing method for polishing a surface to be polished with a polishing pad while controlling the temperature of the polishing pad by blowing a gas toward the polishing pad, said method comprising:
monitoring the polishing state of the surface to be polished during polishing and, when a predetermined thickness of a film to be polished is reached, predicting a polishing end time; and
controlling the blowing of the gas so that the temperature of the polishing pad reaches a predetermined temperature at the polishing end time.

7. A polishing apparatus for polishing a substrate comprising:
a gas blow section for blowing a gas toward a polishing pad to control the temperature of the polishing pad;
a controller for PID-controlling the flow rate or the blow direction of the gas blown from the gas blow section; and
a monitor for monitoring the polishing state of a surface to be polished,
wherein a recipe, which indicates a relationship between the control temperature of the polishing pad and the thickness of a film to be polished, is stored in the controller, and
wherein the controller and the monitor are configured to operate based on the recipe and change the control temperature of the polishing pad according to the thickness of the film.

8. The polishing apparatus according to claim 7, further comprising:
a cleaning tool for cleaning the gas blow section.

9. The polishing apparatus according to claim 7, wherein the gas blow section is comprised of at least one of a cooling nozzle for blowing the dry gas toward the polishing pad and a cooling fan for blowing the dry gas toward the polishing pad.

10. The polishing apparatus according to claim 7, further comprising:
a temperature sensor for detecting the temperature of the polishing pad; and
a temperature controller for controlling, based on a detection value of the temperature sensor, an amount of the dry gas to be supplied from the gas blow section to the polishing pad.

11. A method for polishing a substrate by bringing the substrate into sliding contact with a polishing pad, said method comprising:
rotating a polishing table holding the polishing pad;
pressing a surface of the substrate against the polishing pad;
supplying a slurry to the polishing pad;
blowing a gas toward the polishing pad while controlling a flow rate or a blow direction of the gas by PID-control so that a temperature of the polishing pad becomes a first control temperature;
monitoring a polishing state of the substrate; and
blowing a gas toward the polishing pad while controlling a flow rate or a blow direction of the gas by PID-control so that a temperature of the polishing pad becomes a second control temperature after the polishing state is detected to be a predetermined state.

12. The polishing method according to claim 11, wherein a dry gas is used as the gas before the polishing state is detected to be the predetermined state, and a mist is used as the gas after the polishing state is detected to be the predetermined state.

13. The polishing method according to claim 11, wherein polishing is carried out at a first polishing pressure before the polishing state is detected to be the predetermined state and, after the polishing state is detected to be the predetermined state, polishing is carried out at a second polishing pressure which is lower than the first polishing pressure.

14. The polishing method according to claim 11, wherein the monitoring of the polishing state of the substrate is performed by using an eddy current sensor, an optical sensor or a torque current sensor.
